(19) Europäisches Patentamt
European Patent Office
Office européen des brevets

(11) **EP 4 081 817 B1**

(12) **FASCICULE DE BREVET EUROPEEN**

(45) Date de publication et mention
de la délivrance du brevet:
**14.02.2024 Bulletin 2024/07**

(21) Numéro de dépôt: **20821302.5**

(22) Date de dépôt: **15.12.2020**

(51) Classification Internationale des Brevets (IPC):
**G01R 31/392** *(2019.01)*   **B60L 58/16** *(2019.01)*
**H02J 7/00** *(2006.01)*   *B60L 53/14* *(2019.01)*

(52) Classification Coopérative des Brevets (CPC):
**G01R 31/392; B60L 53/14; B60L 58/16;**
**H02J 7/005;** Y02T 10/7072; Y02T 90/14

(86) Numéro de dépôt international:
**PCT/EP2020/086298**

(87) Numéro de publication internationale:
**WO 2021/130068 (01.07.2021 Gazette 2021/26)**

(54) **PROCÉDÉ D'IDENTIFICATION DU DÉBUT DE L'ACCÉLÉRATION DE LA DÉGRADATION DE L'ÉTAT DE SANTÉ DE BATTERIES D'ACCUMULATEURS ÉLECTRIQUES**

VERFAHREN ZUM IDENTIFIZIEREN DES BEGINNS DER BESCHLEUNIGUNG DER VERSCHLECHTERUNG DES GESUNDHEITSZUSTANDS EINES PACKS VON WIEDERAUFLADBAREN BATTERIEN

METHOD FOR IDENTIFYING THE START OF THE ACCELERATION OF THE DEGRADATION OF THE STATE OF HEALTH OF A PACK OF RECHARGEABLE BATTERIES

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **23.12.2019 FR 1915398**

(43) Date de publication de la demande:
**02.11.2022 Bulletin 2022/44**

(73) Titulaire: **Renault s.a.s**
**92100 Boulogne Billancourt (FR)**

(72) Inventeurs:
• **GOHIER, Aurélien**
**91300 Massy (FR)**
• **JIMENEZ-GORDON, Isabel**
**75015 Paris (FR)**

(56) Documents cités:
**EP-A2- 1 263 111    EP-A2- 2 889 633**

• **SU LAISUO ET AL: "Identifying main factors of capacity fading in lithium ion cells using orthogonal design of experiments", APPLIED ENERGY, ELSEVIER SCIENCE PUBLISHERS, GB, vol. 163, 5 décembre 2015 (2015-12-05), pages 201-210, XP029347291, ISSN: 0306-2619, DOI: 10.1016/J.APENERGY.2015.11.014**
• **JUFENG YANG ET AL: "Online state-of-health estimation for lithium-ion batteries using constant-voltage charging current analysis", APPLIED ENERGY., vol. 212, 1 février 2018 (2018-02-01), pages 1589-1600, XP055722644, GB ISSN: 0306-2619, DOI: 10.1016/j.apenergy.2018.01.010**

EP 4 081 817 B1

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**Description**

L'invention concerne un procédé d'identification du début de l'accélération de la dégradation de l'état de santé de batteries d'accumulateurs électriques, notamment des batteries Li-ion.

Plus particulièrement, l'invention concerne la gestion de batteries d'accumulateurs électriques pour un véhicule automobile électrique ou hybride.

L'un des forts enjeux pour le développement des véhicules électriques tient à la durabilité des batteries lithium-ion, car il est nécessaire de garantir une autonomie minimale aux utilisateurs pendant tout le temps d'utilisation du véhicule.

En général, la dégradation de l'état de santé (en anglais *state of health,* fréquemment abrégé SOH) des batteries Li-ion arrive de façon progressive. Néanmoins, certaines conditions d'utilisation vont provoquer une accélération non attendue de leur dégradation. Ce type de dégradation, aussi appelée mort subite de la batterie, limite l'autonomie du véhicule de manière pénalisante pour l'utilisateur.

Or, ce type de dégradation n'est pas prise en compte dans les modèles d'estimation de durée de vie empiriques de batteries, qui sont fréquemment embarqués dans le véhicule automobile, et qui calculent le SOH selon la perte de capacité et/ou d'autres indicateurs de performance, en suivant des lois linéaires ou de puissance.

Aussi, un problème connu est de pouvoir anticiper la dégradation subite des batteries électriques en temps réel, notamment dans un véhicule électrique.

On connaît notamment dans l'art antérieur le document de brevet FR2966250 A1 qui décrit un procédé d'estimation de l'état de santé de la batterie à travers les mesures environnementales et la capacité réelle de la batterie. Toutefois ce document ne permet pas d'identifier le début de l'accélération de la dégradation de l'état de santé. En outre, le document de brevet EP 2 889 633 A2 divulgue un procédé d'identification de la dégradation de l'état de santé d'une batterie d'accumulateur électrique, ladite batterie étant chargée selon une phase de charge dynamique suivie d'une phase de charge passive, le procédé d'identification mettant en oeuvre les étapes suivantes: mesurer, pendant chaque charge de la batterie, la durée de ladite phase de charge passive jusqu'à une valeur d'état de charge prédéterminée; et calculer, après chaque charge de la batterie, un taux d'augmentation de la durée de la phase de charge passive mesurée par rapport à une durée de référence de la phase de charge passive jusqu'à ladite valeur d'état de charge prédéterminée. De plus, le document de brevet EP 1 263 111 A2 et les articles "Identifying main factors of capacity fading in lithium ion cells using orthogonal design of experiments" (SU LAISUO ET AL) et "Online state-of-health estimation for lithium-ion batteries using constant-voltage charging current analysis" (JUFENG YANG ET AL) divulguent d'autres procédés d'identification de la dégradation de l'état de santé d'une batterie d'accumulateur électrique.

Aussi, il existe le besoin d'une solution pour identifier plus rapidement le début de l'accélération de la dégradation de l'état de santé d'une batterie d'accumulateurs électriques.

À cet effet, on propose un procédé d'identification du début de l'accélération de la dégradation de l'état de santé d'une batterie d'accumulateur électrique, ladite batterie étant chargée selon une phase de charge dynamique suivie d'une phase de charge passive, notamment à potentiel constant ou à courants faibles ou encore à puissances faibles.

Le procédé d'identification met en oeuvre les étapes suivantes :

- Acquérir, pour chaque charge de la batterie, une quantité cumulée d'énergie déchargée par la batterie lors d'une phase précédente de décharge ;
- Mesurer, pendant chaque charge de la batterie, la durée de ladite phase de charge passive jusqu'à une valeur d'état de charge prédéterminée ;
- Calculer, après chaque charge de la batterie, un taux d'augmentation de la durée de la phase de charge passive mesurée par rapport à une durée de référence de la phase de charge passive jusqu'à ladite valeur d'état de charge prédéterminée, et
- Déterminer une fonction représentative de la progression dudit taux d'augmentation de la durée de charge passive en fonction de la quantité cumulée d'énergie déchargée par la batterie ; et
- Identifier le début de l'accélération de la dégradation de l'état de santé de la batterie lorsque les taux d'augmentation calculés ne progressent plus en suivant ladite fonction.

Ainsi, on peut identifier le point de départ de l'accélération de la dégradation de manière relativement simple et robuste. Cet indicateur pourra devenir visible pendant les diagnostiques pour mieux gérer les véhicules électrifiés. L'estimation est faite à partir des données caractéristiques de la charge qui sont relativement simples à récupérer par le calculateur de la batterie, ce qui rend le procédé relativement bien adapté à être embarqué dans le véhicule automobile.

Avantageusement et de manière non limitative, la fonction représentative de la progression du taux d'augmentation de la durée de charge passive en fonction de la quantité cumulée d'énergie déchargée est linéaire. Ainsi, on peut identifier ledit début de l'accélération de la dégradation de l'état de santé de la batterie d'accumulateurs électrique lorsque la progression des taux d'augmentation calculés ne suit plus ladite progression linéaire de ladite fonction linéaire déterminée. Ceci constitue un critère relativement fiable et relativement simple à déterminer, en particulier par un calculateur embarqué.

Avantageusement et de manière non limitative, l'étape d'identification inclut de déterminer un taux d'augmentation limite et d'en déduire la quantité cumulée limite d'énergie déchargée par la batterie correspondant à son antécédent par la fonction ; et en ce qu'on identifie le début de l'accélération de la dégradation de l'état de santé de la batterie lorsque la quantité cumulée d'énergie déchargée par la batterie lors de la décharge précédente atteint ou dépasse ladite quantité cumulée limite. Ainsi, on peut identifier de manière anticipée, autrement dit on peut prédire, le début de l'accélération de la dégradation. Ceci peut notamment être utile pour la maintenance préventive.

Avantageusement et de manière non limitative, la durée de référence de la phase de charge passive est calculée en fonction d'une valeur moyenne de la durée des phases de charges passives d'une pluralité de charges en début de vie de la batterie. Ainsi, on peut définir une durée de référence relativement simplement et avec un coût calculatoire particulièrement faible.

Avantageusement et de manière non limitative, la fonction linéaire est obtenue par le calcul d'un ajustement affine d'une pluralité de taux d'augmentation calculés en fonction de la quantité cumulée d'énergie déchargée par la batterie. Ainsi, on peut obtenir une fonction linéaire particulièrement précise et relativement simple à calculer.

Selon une alternative avantageuse, la fonction linéaire est une fonction précalculée. Ce qui diminue de manière très importante la quantité de calcul à réaliser par le dispositif embarqué.

L'invention concerne aussi un procédé de charge d'une batterie d'accumulateur électrique incluant le procédé d'identification tel que décrit précédemment.

L'invention concerne aussi un dispositif d'identification du début de l'accélération de la dégradation de l'état de santé d'une batterie d'accumulateur électrique, ladite batterie étant chargée selon une phase de charge dynamique suivie d'une phase de charge passive.

Le dispositif d'identification comprend :

- Des moyens d'acquisition d'une quantité cumulée d'énergie déchargée par la batterie lors des phases de décharge ;
- Des moyens de mesure de la durée de chaque phase de charge passive ;
- Des moyens de calcul d'un taux d'augmentation de la durée de chaque phase de charge passive mesurée par rapport à une durée de référence, et
- Des moyens de détermination d'une fonction représentative de la progression du taux d'augmentation de la durée de charge passive en fonction de la quantité cumulée d'énergie déchargée par la batterie ; et
- Des moyens d'identification du début de l'accélération de la dégradation de l'état de santé de la batterie lorsque les taux d'augmentation calculés ne progressent plus en suivant ladite fonction.

L'invention concerne aussi un ensemble électrique comprenant une batterie d'accumulateur électrique, un dispositif de gestion de la charge de ladite batterie adapté pour commander une recharge de la batterie selon un procédé comprenant une phase de charge dynamique et une phase de charge passive et un dispositif d'identification du début de l'accélération de la dégradation de l'état de santé d'une batterie d'accumulateur électrique tel que décrit précédemment.

L'invention concerne aussi un véhicule automobile comprenant un ensemble électrique tel que décrit précédemment.

D'autres particularités et avantages de l'invention ressortiront à la lecture de la description faite ci-après de deux modes de réalisation particuliers de l'invention, donné à titre indicatif mais non limitatif, en référence aux dessins annexés sur lesquels :

[Fig. 1] est un organigramme du procédé de l'invention selon un premier mode de réalisation de l'invention ;

[Fig. 2] est un organigramme du procédé de l'invention selon un deuxième mode de réalisation de l'invention ;

[Fig. 3] est une représentation graphique des différentes expressions de l'état de santé d'une batterie, et de sa résistance interne (connue sous le nom de DCR), en fonction de l'énergie totale cumulée pendant le cyclage d'une cellule Li-ion conçue pour une application en véhicule électrique ;

[Fig. 4] est une représentation du pourcentage de temps ce charge passé dans la phase dynamique et dans la phase passive ainsi que le temps total de charge en fonction de l'énergie déchargée cumulée pendant le cyclage d'une cellule Li-ion conçue pour application en véhicule électrique ; et

[Fig. 5] est une représentation graphique des taux d'augmentation de temps en phase passive de la charge en fonction de l'énergie déchargée cumulée pendant le cyclage d'une cellule Li-ion conçue pour application en véhicule électrique.

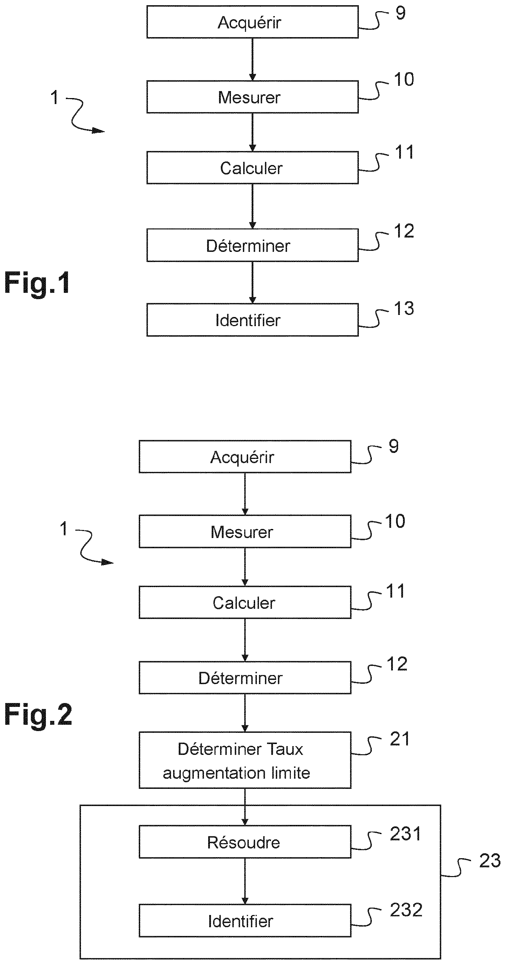

Selon un premier mode de réalisation de l'invention, en référence aux figures 1 et 3 à 5, on met en oeuvre un procédé d'identification du début de l'accélération de la dégradation de l'état de santé (abrégé dans la suite de la description par SOH) d'une batterie d'accumulateurs électriques d'un véhicule automobile.

Dans un véhicule automobile, le procédé 1,1' selon l'invention est mis en oeuvre par un calculateur, par exemple un calculateur embarqué lorsque l'identification est mise en oeuvre automatique ou un calculateur externe par exemple lorsqu'il est mis en oeuvre lors d'une phase de maintenance.

A cet effet le calculateur embarqué communique ou est le même que le calculateur de gestion de la charge de batteries du véhicule automobile.

Le calculateur peut être choisi parmi les calculateurs connus de l'homme du métier, dès lors que le calculateur comprend les moyens de calcul, de stockage et de communication nécessaire à la mise en oeuvre du procédé décrit.

L'état de santé d'une batterie peut être défini de deux manière principales différentes.

D'une part l'état de santé peut être défini selon la capacité restante dans la cellule, abrégé SOHQ selon l'équation suivante :

[Math 1]

$$SOHQ = \frac{Q_{MOL_x}}{Q_{BOL}} \times 100$$

*Avec*

$Q_{MOL_x}$ : capacité (Ah) déchargée de 100 à 0% SOC à un C-rate donné au temps « *Middle of Life* » (MOL) x.

$Q_{BOL}$ : capacité (Ah) déchargée de 100 à 0% SOC à un C-rate donné au début de vie ou « *Beginning of Life* » (BOL).

Le C-rate (exprimé en h$^{-1}$) est une valeur bien connue de l'homme du métier qui constitue une mesure de la vitesse à laquelle une batterie est déchargée. Le C-rate est défini comme le rapport entre le courant de décharge et la consommation de courant théorique en vertu de laquelle la batterie délivrerait sa capacité nominale en une heure.

L'état de santé peut aussi être défini selon l'énergie restante dans la batterie, abrégé SOHE, selon l'équation suivante :

[Math 2]

$$SOHE = \frac{E_{MOL_x}}{E_{BOL}} \times 100$$

Avec :

$E_{MOL_x}$ : énergie (Wh) déchargée de 100 à 0% SOC à un C-rate donné au temps MOLx.

$E_{BOL}$ : énergie (Wh) déchargée de 100 à 0% SOC à un C-rate donné en début de vie.

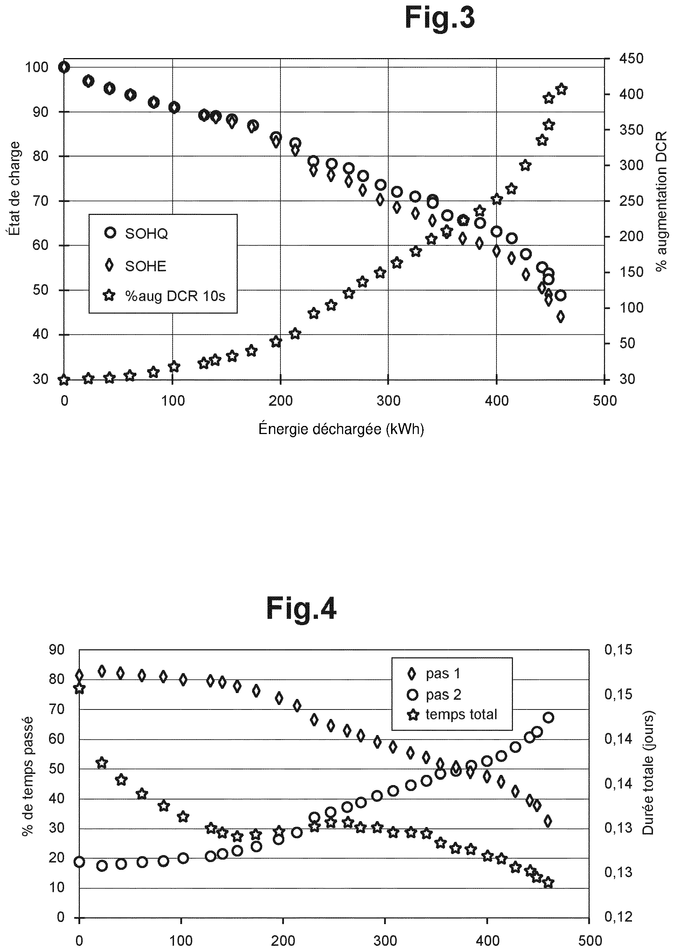

Toutefois on remarque, en référence à la figure 3, que l'évolution de ces deux SOH : SOHQ et SOHE est sensiblement similaire lors de la dégradation de la santé de la batterie, et en ce sens l'identification du début de cette dégradation peut s'effectuer de manière égale par le calcul de l'un ou l'autre des SOH.

On remarque en outre, toujours en référence à la figure 3, que l'accélération de la dégradation du SOH de la batterie est concomitante avec une forte augmentation de la résistance.

Aussi bien que la résistance puisse constituer un indicateur pertinent de la mort subite, il n'est pas toujours possible en pratique de faire des mesures de résistance fiables.

Aussi, le procédé 1 selon l'invention vise à estimer le début de l'accélération de la dégradation du SOH selon l'évolution des caractéristiques de la charge de la batterie.

On entend par le terme début, ou point de départ, un instant à partir duquel on identifie le début de l'accélération de la dégradation de l'état de santé de la batterie.

Aussi, le terme début ne doit pas être compris comme un instant précis au cours duquel un événement particulier viendrait endommager la batterie, mais un instant, ou une période de temps relativement faible à l'échelle de la durée de vie de la batterie d'accumulateurs électrique, au cours de laquelle on identifie ou détecte qu'une accélération notable de la dégradation de l'état de santé de la batterie se produit.

En général, dans le cas des batteries Li-ion conçues pour véhicules électrifiées, véhicule électrique (*Electric Vehicle,* abrégé en EV) ou véhicule hybride rechargeable (*Plugin Electric Hydrid Vehicle,* abrégé PHEV), on peut diviser la charge en deux phases successives :

- Une phase dynamique, aussi appelée Pas 1 au cours de laquelle un ou plusieurs pics de puissance et/ou de courant sont appliqués jusqu'à un état de charge limite (appelé en anglais *State-Of-Charge,* SOC) formant condition d'arrêt de la phase dynamique et/ou jusqu'à une tension limite.

- Une phase passive, aussi appelée Pas 2 : au cours de laquelle on applique une charge passive à haut niveau d'énergie. Au cours de la phase passive, on applique soit un potentiel fixe (*constant voltage,* ou CV) pendant un temps défini, soit plusieurs pics de courants et/ou puissances faibles peuvent être appliqués.

La phase dynamique est affectée par l'augmentation de la résistance de la batterie après dégradation exposée précédemment en référence à la figure 3.

En référence à la figure 4, cette augmentation va générer une polarisation pendant la charge, et par conséquent l'état de charge limite et/ou la tension limite pour l'arrêt de la phase dynamique sera atteint plus vite. À contrario, la phase passive devient plus longue.

Dans le cas d'une utilisation de la batterie en véhicule électrifié, il est relativement peu fréquent que l'utilisateur du véhicule décharge entièrement la batterie, et par conséquent quand une charge de batterie est initialisée, l'état de charge est généralement non nul mais non prévisible, puisqu'il dépend, au cas par cas, de l'utilisation faite du véhicule avant cette charge.

Dans ce sens, il s'avère difficile de suivre l'évolution de la phase dynamique pendant le vieillissement de la batterie, car le temps passé pour la phase dynamique est fonction de la valeur d'état de charge de départ.

Toutefois, les utilisateurs ont généralement tendance à charger la batterie jusqu'à l'état de charge maximal autorisé. Aussi, il apparait plus probable que la phase passive soit complète plus régulièrement.

Aussi, le procédé 1 selon l'invention comprend l'identification du début de l'accélération de la dégradation de la batterie en fonction de l'évolution de valeurs caractéristiques de la charge.

Ces valeurs peuvent être de manière avantageuse, conformément à ce qui est exposé précédemment, le temps de charge lors de la phase passive, la capacité et/ou l'énergie enregistrés pour la phase passive.

L'identification du début peut être réalisée à partir d'un seul de ces paramètres ou d'une combinaison de ces paramètres.

Aussi selon une première étape du procédé 1, on mesure 10, pour chaque charge de la batterie, la durée de phase de charge passive à potentiel constant.

Puis on calcule 11, pour chaque charge de la batterie, un taux d'augmentation de la durée de la phase de charge par rapport à la charge précédente.

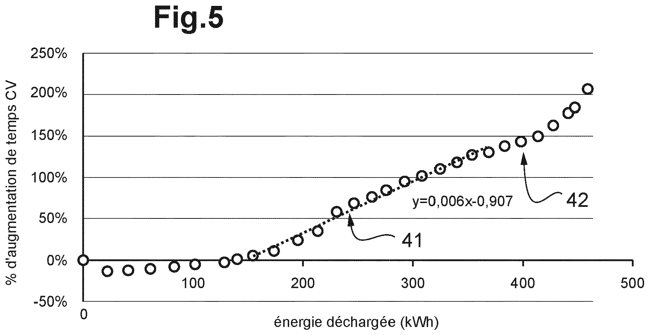

À titre d'exemple, en référence à la figure 5, on observe le taux d'augmentation, ici en pourcentage, du temps de charge à potentiel fixe de la phase passive de la charge pendant le vieillissement. Au début, la durée à potentiel fixe de la phase passive n'augmente pas, même si le SOH de la cellule se dégrade, par comparaison avec la figure 3.

Ensuite on détermine 11 une fonction linéaire représentative de la progression des taux d'augmentation calculés.

Lorsque la progression des taux d'augmentation calculés ne suit plus une progression linéaire 12, alors on a identifié 13 le début de l'accélération de la dégradation de l'état de santé de la batterie d'accumulateurs électrique.

En référence à l'exemple de la figure 5, on observe que le pourcentage d'augmentation du temps à potentiel constant augmente de manière linéaire 41.

La fonction linéaire de croissance des taux d'augmentation du temps à potentiel constant est dans cet exemple de la forme $f(x) = 0.006x - 0{,}907$ ; avec x la quantité cumulée d'énergie déchargée par la batterie (en kWh).

Cette fonction linéaire est obtenue par un ajustement affine d'au moins deux, et préférentiellement plus de deux, valeurs d'augmentation calculées.

Il existe de nombreuses méthodes de calcul d'un ajustement affine, tel que la méthode des moindres carrés, la méthode de Mayer, ou encore une régression linéaire.

La droite obtenue par un ajustement affine, généralement appelée droite de tendance, peut alors être recalculée à chaque charge, en particulier pendant les premières recharges pour lesquelles une croissance des taux d'augmentation, par exemple les 2 à 10 premières recharges suivant le début de la croissance des taux d'augmentation, car il est probable qu'il s'agisse de la phase de croissance linéaire.

Selon une alternative de mise en oeuvre, la fonction linéaire peut être précalculée en fonction des performances attendues de la batterie.

Toute autre méthode de définition de la fonction linéaire peut être mise en oeuvre, tel que des algorithmes d'apprentissage automatique,

Aussi, lorsque le pourcentage d'augmentation du temps à potentiel constant sort de sa zone de croissance linéaire 41, l'accélération 42 de la dégradation se produit. Par conséquent l'indication d'accélération de la dégradation de l'état de santé de la batterie est définie lorsque le pourcentage d'augmentation du temps à potentiel constant sort de la zone de croissance linéaire.

On constate la sortie de la zone de croissance linéaire lorsque la valeur s'écarte au-delà d'une limite prédéfinie de la fonction linéaire calculée.

Dans cet exemple le taux d'augmentation du temps à potentiel constant de la phase passive est exprimé en pourcentage d'augmentation.

Ce pourcentage d'augmentation correspondant au rapport entre la durée de la phase passive lors de la dernière charge par rapport à une durée de référence de la phase passive, par exemple une durée moyenne de la phase passive lors des premières recharges de la batterie, ou une valeur prédéterminée correspondant à une durée théorique ou nominale. Toutefois l'invention n'est nullement limitée à ce dimensionnement particulier et pourra être exprimée et mesurée selon toute autre unité de taux pertinente.

Selon un deuxième mode de réalisation de l'invention en référence à la figure 2 et aux figures 3 à 5, on calcule une prédiction du début de l'accélération de la dégradation, à partir de l'évolution des caractéristiques de la phase passive de la charge.

Dans une étape précédant l'étape d'identification 23 du procédé 1' selon ce deuxième mode de réalisation, on détermine 21, par exemple lors d'essais ou par simulation, un taux d'augmentation limite au-delà duquel il est relativement probable que l'accélération de la dégradation ait lieu.

Aussi, à titre d'exemple, par observation de la figure 5, on remarque que le début de l'accélération de la dégradation se produit lorsqu'est atteint sensiblement 150% d'augmentation du temps à potentiel constant.

En utilisant cette valeur d'augmentation limite, le début de l'accélération de la dégradation peut être estimé à partir la pente de la fonction linéaire 41 calculée selon le premier mode de réalisation.

Or dans un véhicule automobile électrique, ou hybride rechargeable, la valeur d'énergie déchargée cumulée en fonction du temps d'utilisation aussi appelée quantité cumulée d'énergie déchargée par la batterie, et qui est liée au temps d'utilisation du véhicule, est régulièrement enregistrée.

Aussi au cours de l'étape d'identification 23, connaissant la fonction linéaire 41, on la résoudre 231 et on calcule ainsi à quelle quantité cumulée d'énergie déchargée correspond à la valeur d'augmentation limite, de sorte qu'on peut identifier 232 par anticipation une quantité cumulée d'énergie déchargée limite, et avertir l'utilisateur par anticipation du risque de début d'accélération de la dégradation de la batterie.

Selon l'exemple de la figure 5, la valeur cumulée serait atteinte pour (par calcul de la valeur de x de la fonction affine définie lors du premier mode de réalisation) :

$$x= (1.5+0.907)/0.006$$

Soit une valeur cumulée de sensiblement 401,16 kWh.

Le procédé selon l'invention peut par ailleurs combiner l'identification du premier mode de réalisation et l'identification du second mode de réalisation, de sorte qu'on peut identifier par anticipation le début d'une accélération probable, avec le procédé selon le deuxième mode de réalisation, tout en effectuant une identification en temps réel apte à avertir l'utilisateur si l'accélération se produisait avant la prédiction.

## Revendications

1. Procédé (1, 1') d'identification du début de l'accélération de la dégradation de l'état de santé d'une batterie d'accumulateur électrique, ladite batterie étant chargée selon une phase de charge dynamique suivie d'une phase de charge passive ; le procédé (1, 1') d'identification mettant en oeuvre les étapes suivantes :

   - Acquérir (9), pour chaque charge de la batterie, une quantité cumulée d'énergie déchargée par la batterie lors de la phase précédente de décharge ;
   - Mesurer (10), pendant chaque charge de la batterie, la durée de ladite phase de charge passive jusqu'à une valeur d'état de charge prédéterminée ;
   - Calculer (11), après chaque charge de la batterie, un taux d'augmentation de la durée de la phase de charge passive mesurée par rapport à une durée de référence de la phase de charge passive jusqu'à ladite valeur d'état de charge prédéterminée, et
   - Déterminer (12) une fonction (41) représentative de la progression dudit taux d'augmentation de la durée de charge passive en fonction de la quantité cumulée d'énergie déchargée par la batterie ; et
   - Identifier (13, 23) le début de l'accélération de la dégradation de l'état de santé de la batterie lorsque les taux d'augmentation calculés ne progressent plus en suivant ladite fonction.

2. Procédé (1) selon la revendication 1, **caractérisé en ce que** la fonction représentative de la progression du taux d'augmentation de la durée de charge passive en fonction de la quantité cumulée d'énergie déchargée est linéaire.

3. Procédé (1') selon la revendication 1 ou 2, **caractérisé en ce que** l'étape d'identification (23) inclut de déterminer (21) un taux d'augmentation limite et d'en déduire la quantité cumulée limite d'énergie déchargée par la batterie correspondant à son antécédent par la fonction ; et **en ce qu'**on identifie (232) le début de l'accélération de la dégradation de l'état de santé de la batterie lorsque la quantité cumulée d'énergie déchargée par la batterie lors de la décharge précédente atteint ou dépasse ladite quantité cumulée limite.

4. Procédé (1, 1') selon l'une quelconque des revendications 1 à 3, **caractérisé en ce que** la durée de référence de la phase de charge passive est calculée en fonction d'une valeur moyenne de la durée des phases de charges passives d'une pluralité de charges en début de vie de la batterie.

5. Procédé (1, 1') selon l'une quelconque des revendications 2 à 4, **caractérisé en ce que** la fonction linéaire est obtenue par le calcul d'un ajustement affine d'une pluralité de taux d'augmentation calculés en fonction de la quantité cumulée d'énergie déchargée par la batterie.

6. Procédé (1, 1') selon l'une quelconque des revendications 2 à 4, **caractérisé en ce que** la fonction linéaire est une fonction précalculée.

7. Procédé de charge d'une batterie d'accumulateur électrique incluant le procédé d'identification selon l'une quelconque des revendications précédentes.

8. Dispositif d'identification du début de l'accélération de la dégradation de l'état de santé d'une batterie d'accumulateur électrique, ladite batterie étant chargée selon une phase de charge dynamique suivie d'une phase de charge passive ; le dispositif d'identification comprenant :

   - Des moyens d'acquisition d'une quantité cumulée d'énergie déchargée par la batterie lors des phases de décharge ;
   - Des moyens de mesure de la durée de chaque phase de charge passive ;
- Des moyens de calcul d'un taux d'augmentation de la durée de chaque phase de charge passive mesurée par rapport à une durée de référence, et
- Des moyens de détermination d'une fonction (41) représentative de la progression du taux d'augmentation de la durée de charge passive en fonction de la quantité cumulée d'énergie déchargée par la batterie ; et
- Des moyens d'identification du début de l'accélération de la dégradation de l'état de santé de la batterie lorsque les taux d'augmentation calculés ne progressent plus en suivant ladite fonction.

9. Ensemble électrique comprenant une batterie d'accumulateur électrique, un dispositif de gestion de la charge de ladite batterie adapté pour commander une recharge de la batterie selon un procédé comprenant une phase de charge dynamique et une phase de charge passive et un dispositif d'identification du début de l'accélération de la dégradation de l'état de santé d'une batterie d'accumulateur électrique selon la revendication 8.

10. Véhicule automobile comprenant un ensemble électrique selon la revendication 9.


**Patentansprüche**

1. Verfahren (1, 1') zur Identifizierung des Beginns der Beschleunigung der Verschlechterung des Gesundheitszustands einer elektrischen Akkumulatorenbatterie, wobei die Batterie gemäß einer dynamischen Ladephase gefolgt von einer passiven Ladephase geladen wird;
wobei das Identifizierungsverfahren (1, 1') die folgenden Schritte durchführt:

- Erfassen (9), für jedes Laden der Batterie, einer kumulierten Energiemenge, die von der Batterie bei der vorhergehenden Entladephase entladen wurde;
- Messen (10), während jedes Ladens der Batterie, der Dauer der passiven Ladephase bis zu einem vorbestimmten Ladezustandswert;
- Berechnen (11), nach jedem Laden der Batterie, einer Anstiegsrate der gemessenen Dauer der passiven Ladephase bezüglich einer Bezugsdauer der passiven Ladephase bis zum vorbestimmten Ladezustandswert, und
- Bestimmen (12) einer Funktion (41), die für das Fortschreiten der Anstiegsrate der passiven Ladedauer abhängig von der von der Batterie entladenen kumulierten Energiemenge repräsentativ ist; und

- Identifizieren (13, 23) des Beginns der Beschleunigung der Verschlechterung des Gesundheitszustands der Batterie, wenn die berechneten Anstiegsraten nicht mehr entsprechend der Funktion fortschreiten.

2. Verfahren (1) nach Anspruch 1, **dadurch gekennzeichnet, dass** die für das Fortschreiten der Anstiegsrate der passiven Ladedauer abhängig von der kumulierten Menge entladener Energie repräsentative Funktion linear ist.

3. Verfahren (1') nach Anspruch 1 oder 2, **dadurch gekennzeichnet, dass** der Identifizierungsschritt (23) enthält, eine Grenzanstiegsrate zu bestimmen (21) und daraus die kumulierte Grenzmenge von von der Batterie entladener Energie entsprechend ihrem Vorgänger durch die Funktion abzuleiten; und dass der Beginn der Beschleunigung der Verschlechterung des Gesundheitszustands der Batterie identifiziert wird (232), wenn die kumulierte Menge von von der Batterie entladener Energie bei der vorhergehenden Entladung die kumulierte Grenzmenge erreicht oder überschreitet.

4. Verfahren (1, 1') nach einem der Ansprüche 1 bis 3, **dadurch gekennzeichnet, dass** die Bezugsdauer der passiven Ladephase abhängig von einem Mittelwert der Dauer der passiven Ladephasen einer Vielzahl von Ladungen zu Beginn der Lebensdauer der Batterie berechnet wird.

5. Verfahren (1, 1') nach einem der Ansprüche 2 bis 4, **dadurch gekennzeichnet, dass** die lineare Funktion durch die Berechnung einer affinen Anpassung einer Vielzahl von Anstiegsraten erhalten wird, die abhängig von der kumulierten Menge von von der Batterie entladener Energie berechnet werden.

6. Verfahren (1, 1') nach einem der Ansprüche 2 bis 4, **dadurch gekennzeichnet, dass** die lineare Funktion eine vorberechnete Funktion ist.

7. Verfahren zum Laden einer elektrischen Akkumulatorenbatterie, das das Identifizierungsverfahren nach einem der vorhergehenden Ansprüche enthält.

8. Vorrichtung zur Identifizierung des Beginns der Beschleunigung der Verschlechterung des Gesundheitszustands einer elektrischen Akkumulatorenbatterie, wobei die Batterie gemäß einer dynamischen Ladephase gefolgt von einer passiven Ladephase geladen wird;
wobei die Identifizierungsvorrichtung enthält:

- Einrichtungen zur Erfassung einer kumulierten Menge von durch die Batterie in den Entladephasen entladener Energie;

- Einrichtungen zur Messung der Dauer jeder passiven Ladephase;
- Einrichtungen zur Berechnung einer Anstiegsrate der Dauer jeder passiven Ladephase gemessen bezüglich einer Bezugsdauer, und
- Einrichtungen zur Bestimmung einer für das Fortschreiten der Anstiegsrate der passiven Ladedauer repräsentativen Funktion (41) abhängig von der kumulierten Menge von von der Batterie entladener Energie; und
- Einrichtungen zur Identifizierung des Beginns der Beschleunigung der Verschlechterung des Gesundheitszustands der Batterie, wenn die berechneten Anstiegsraten nicht mehr entsprechend der Funktion fortschreiten.

9. Elektrische Einheit, die eine elektrische Akkumulatorenbatterie, eine Verwaltungsvorrichtung des Ladens der Batterie, die geeignet ist, ein Aufladen der Batterie gemäß einem Verfahren zu steuern, das eine dynamische Ladephase und eine passive Ladephase enthält, und eine Vorrichtung zur Identifizierung des Beginns der Beschleunigung der Verschlechterung des Gesundheitszustands einer elektrischen Akkumulatorenbatterie nach Anspruch 8 enthält.

10. Kraftfahrzeug, das eine elektrische Einheit nach Anspruch 9 enthält.

**Claims**

1. Method (1, 1') for identifying the start of acceleration of the degradation of the state of health of an electric accumulator battery, said battery being charged in a dynamic charging phase followed by a passive charging phase;
the identifying method (1, 1') implementing the following steps:

   - acquiring (9), for each charge of the battery, a cumulative amount of energy discharged by the battery in the preceding discharging phase;
   - measuring (10), during each charge of the battery, the duration of said passive charging phase to a predetermined state-of-charge value;
   - computing (11), after each charge of the battery, a degree of increase in the measured duration of the passive charging phase with respect to a reference duration of the passive charging phase to said predetermined state-of-charge value; and
   - determining (12) a function (41) representative of the progression of said degree of increase in the duration of passive charging as a function of the cumulative amount of energy discharged by the battery; and

   - identifying (13, 23) the start of acceleration of the degradation of the state of health of the battery when the computed degrees of increase no longer progress according to said function.

2. Method (1) according to Claim 1, **characterized in that** the function representative of the progression of the degree of increase in the duration of passive charging as a function of the cumulative amount of energy discharged is linear.

3. Method (1') according to Claim 1 or 2, **characterized in that** the identifying step (23) includes determining (21) a limit degree of increase and deducing therefrom the limit cumulative amount of energy discharged by the battery corresponding to its antecedent using the function; and **in that** the start of acceleration of the degradation of the state of health of the battery is identified (232) when the cumulative amount of energy discharged by the battery during the preceding discharge reaches or exceeds said limit cumulative amount.

4. Method (1, 1') according to any one of Claims 1 to 3, **characterized in that** the reference duration of the passive charging phase is computed depending on an average value of the duration of the passive charging phases of a plurality of charges at the start of the life of the battery.

5. Method (1, 1') according to any one of Claims 2 to 4, **characterized in that** the linear function is obtained by fitting a straight line to a plurality of computed degrees of increase as a function of the cumulative amount of energy discharged by the battery.

6. Method (1, 1') according to any one of Claims 2 to 4, **characterized in that** the linear function is a precomputed function.

7. Method for charging an electric accumulator battery including the identifying method according to any one of the preceding claims.

8. Device for identifying the start of acceleration of the degradation of the state of health of an electric accumulator battery, said battery being charged in a dynamic charging phase followed by a passive charging phase;
the identifying device comprising:

   - means for acquiring a cumulative amount of energy discharged by the battery in the discharging phases;
   - means for measuring the duration of each passive charging phase;
   - means for computing a degree of increase in the measured duration of each passive charging phase with respect to a reference duration; and
- means for determining a function (41) representative of the progression of the degree of increase in the duration of passive charging as a function of the cumulative amount of energy discharged by the battery; and
- means for identifying the start of acceleration of the degradation of the state of health of the battery when the computed degrees of increase no longer progress according to said function.

9. Electric assembly comprising an electric accumulator battery, a device for managing charging of said battery, which device is suitable for controlling recharging of the battery according to a method comprising a dynamic charging phase and a passive charging phase, and a device for identifying the start of acceleration of the degradation of the state of health of an electric accumulator battery according to Claim 8.

10. Motor vehicle comprising an electric assembly according to Claim 9.

**Fig.1**

1

| Acquérir | 9 |
| Mesurer | 10 |
| Calculer | 11 |
| Déterminer | 12 |
| Identifier | 13 |

**Fig.2**

1

| Acquérir | 9 |
| Mesurer | 10 |
| Calculer | 11 |
| Déterminer | 12 |
| Déterminer Taux augmentation limite | 21 |
| Résoudre | 231 |
| Identifier | 232 |

23

# Fig.3

# Fig.4

# Fig.5

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2966250 A1
- EP 2889633 A2
- EP 1263111 A2

**Littérature non-brevet citée dans la description**

- **SU LAISUO.** *Identifying main factors of capacity fading in lithium ion cells using orthogonal design of experiments*
- **JUFENG YANG.** *Online state-of-health estimation for lithium-ion batteries using constant-voltage charging current analysis*